# EUROPEAN PATENT SPECIFICATION

(11) **EP 1 657 026 B1**
(45) Date of publication and mention of the grant of the patent: **30.03.2016**
(21) Application number: 04748565.1
(22) Date of filing: 08.07.2004
(51) Int. Cl.: B24B 37/04, B24C 1/08, B24B 13/00

(54) **HYDRODYNAMIC RADIAL FLUX TOOL FOR POLISHING AND GRINDING OPTICAL AND SEMICONDUCTOR SURFACES**
VORRICHTUNG ZUR HYDRODYNAMISCHEN ABRASIVEN BEARBEITUNG VON FLÄCHEN VON ELEMENTEN VON OPTISCHEN WERKSTÜCKEN
OUTIL HYDRODYNAMIQUE A FLUX RADIAL POUR LE MEULAGE ET LE POLISSAGE DE SURFACES OPTIQUES ET SEMI-CONDUCTRICES

(30) Priority: 18.07.2003 MX PA03006434
(43) Date of publication of application: 17.05.2006
(73) Proprietor: UNIVERSIDAD NACIONAL AUTONOMA DE MEXICO, México, D.F. 04510 (MX)
(72) Inventor: RUIZ SCHNEIDER, Elfego, Guillermo, C.P. 05500 México (MX); SOHN LOPEZ-FORMENT, Erika, C.P. 10200 México D.F. (MX); SALAS CASALES, Luis, Chapultepec-2da, Sección (MX); LUNA AGUILAR, Esteban, Antolin, C.P.22800 Ensenada, B.C. (MX)
(74) Representative: Zardi, Marco
(86) International application number: PCT/MX2004/000046
(87) International publication number: WO 2005/007343

(56) References cited:
- WO-A-02/074489
- US-B1- 6 354 923

## Description

The following terms are defined for the better understanding of the descriptions given in this document:
**Figuring.-** Process of shaping a solid 3D surface, usually using a mathematical equation by means of rigid, flexible or fluid jet abrasive tools, yielding a final error of around 100 µm.
**Grinding.-** Process used after figuring a surface, consisting of material removal of the surface of a solid by means of shearing, cutting or impacting action of microscopic particles of high hardness (final error of 1-10 µm).
**Fine polishing.-** Final finish of a specular surface with surface errors and micro-roughness smaller than 20 nm.
**Stability.-** The ability of the tool to maintain a constant erosion footprint during operation.
**Repeatability.-** The ability of the tool to maintain a constant erosion footprint during several operating cycles.
**Uniformity.-** The ability of the tool to maintain a constant erosion footprint along its annular circumference.

### Description:

The tool disclosed in this document is useful for the corrective lapping and fine polishing of diverse materials by means of a low cost abrasive flux and a novel suspension system that does not make contact with the working surface. This tool enables to work on flat or curved surfaces of up to two meters in diameter. It has the advantage of avoiding fallen edges during the polishing process as well as avoiding tool wear out and deformation. The polishing process is repeatable by means of the control of the operational parameters of the tool, achieving high degrees of precision and accuracy on optical and semiconductor surfaces, with removal rates of 1 to 300 nm per minute per cm².

This tool allows for interferometric quality tests and measurements during the polishing process without the need of dismounting the working surface.

### Field of the invention

This invention rotates to the field of corrective lapping / grinding and high precision polishing, specifically for optical surfaces as well as the flattening of semiconductor materials.

### Background of the invention

The process of high quality optical polishing consists of material removal from the surface to be polished in order to smoothen it, as well as to correct its figure with precisions of up to fractions of a wavelength.

Conventional polishing methods, also known as classic polishing methods (R.N. Wilson "Reflecting Telescope Optics II, Manufacture, Testing, Alignment Modern Techniques", Springer Verlag, 1999 and Wilson S. R. et al. SPIE VOI 966, 74, 1988), primarily make use of contact tools fabricated with elastic materials such as pitch, polyurethane, etc. that precisely conform themselves to the working surface, abrading it by means of a layer of slurry. These polishing procedures tend to be manual and slow, and the polishing tools tend to strain under the effects of temperature and stresses that are generated during the polishing process, thus wearing away the polishing tool with encrusted abrasive particles and removed material.

These methods have been overcome with the use of so called "stressed lap" polishing tools, which consist of actively deformable polishing tools which ease the polishing of aspheric surfaces. Nevertheless, these methods are complex and one limitation is the impossibility to precisely polish the edges of the working surface, inevitably obtaining fallen edges.

A series of modern methods have been developed that enable the fine polishing of optical surfaces, such as ion beam figuring, magnetorheological polishing and fluid jet polishing. The features and limitations of each of these methods are described:

The ion beam method (USP 5,969,368 and USP 5,786,236) is based on the bombardment of the working surface by means of a collimated ion beam, composed of an inert gas that removes material from the polishing surface.

Although it is possible to polish aspheric surfaces as well as not producing fallen edges, the surface micro-roughness is not improved due to perpendicular impacting of the ions with the surface. Only fine polishing of a previously grinded and polished surface can be achieved with this technology. This process corrects the surface errors iteratively, based on an error map of the working surface.

This method requires the use of a vacuum chamber, at least of the size of the working surface, resulting in an expensive and complex procedure.

The magnetorheological fluid polishing method (USP 5,971,835 and USP 6,106,380) is based on the confinement of a magnetic fluid containing abrasive material over the perimeter of a rotary cylinder which, under the influence of a magnetic field hardens, thus forming a polishing tool. The polishing effect is achieved by moving the working piece in a controlled manner over the hardened magnetorheological polishing fluid that flows over the cylinder.

Another variation of this method consists of collimating a beam of magnetorheological abrasive fluid by means of a magnetic field and impacting it against the working surface.

Although this method generates an annular footprint on the working surface, the areas that can be polished are small (less than 5mm). This limits this technology to industrial applications of small optics such as microscope and camera lenses. This method is expensive.

The fluid jet polishing method (FJP) (Booij, S.M., Optical Engineering, Aug. 2002, Vol. 41, no. 8, pp 1926-1931 and Booij, S. M. et al., I.OF & T conference, Tucson, June 2002, pp. 52-54 and O. Faehnle et al. Appl. Optics 38,6771-673, 1998) is the first polishing technology based on fluids. It produces wear on the working surface by means of an abrasive fluid. The beam is aimed at the surface through a nozzle with a certain angle and distance with respect to the working surface. This polishing method presents certain limitations since the generated footprint is unidirectional and lacks axial symmetry. This method only allows for polishing of small surfaces and the tool presents limitations to satisfy the high precision polishing needs in the field of large area optics.

WO 02/074489 A discloses an example of a high precision hydrodynamic polishing tool, as per the preamble of claim 1.

### Technical Problem

In the high precision optical polishing and microelectronics fields, specifically the precise flattening of semiconductor wafers, the grinding and polishing procedures used make use of a series of modern techniques which nonetheless present certain limitations:
Lap polishing (classic):
   - This method only allows for high hardness materials.
   - The working surface is deformed by the applied tool pressure, requiring the use of rigid supports for the optical piece.
   - Lap tools tend to generate fallen edges due to their semi-rigid contact material and the lack of tool support near the edges of the surface to be polished.
   - It is necessary to change the tool size in order to make zonal corrections.
   - This method uses harmonic machines which do not have the advantages of a Cartesian machine.
Fluid Jet Polishing (FJP):
   - Up to now it is impossible to polish large surfaces (Φ∼1-8 m).
   - Material removal rates are between 100 and 1000 times smaller than the rates obtained with the present invention.
   - The tool footprint does not present radial symmetry; it is not possible to produce a uniform annular print in the plane of incidence; ie. the footprint in the x direction is different form the footprint in the y direction. This complicates the handling of the tool, as well as of the working surface.
Magnetorheological polishing:
   - The main disadvantage of this method is the reduced footprint size that can be generated.
   - It is not possible to generate a uniform annular erosion footprint in the plane of incidence, ie. no axial symmetry exists for the footprint. This complicates the handling of the tool, as well as of the working surface.
Ion beam figuring:
   - A vacuum chamber of at least the size of the surface to be polished is required.
   - It is not possible to make interferometric optical tests during the polishing process, this complicates the iterative polish / test procedure.
   - The surface micro-roughness is not improved due to the normal incidence of the beam on the surface.

One of the main limitations in the available fine polishing and grinding technology is that it is necessary to use more than one polishing technique in order to obtain a high quality, precision optical surface. Currently these techniques are achieved in different geographic locations, complicating the process and significantly elevating the manufacturing costs.

The present invention solves or improves the current technological problems and a series of advantages are obtained with respect to the techniques mentioned earlier in this document.

### Detailed description of the invention.

The present invention is a hydrodynamic polishing tool, as per claim 1, where the polishing principle is based on a radial flux, useful for fine-grinding and polishing of optical and semiconductor surfaces. It is capable of achieving high optical qualities without making contact with the working surface.

This tool supplies a fluid with suspended abrasive particles (slurry) that is propelled by means of pressurized gas (air) that imprints rotational kinetic energy to the slurry, further expelling the abrasive mixture radially and parallel to the working surface, such that the abrasive particles only graze it.

The invention is useful for the fine and high precision grinding and polishing of flat or curved optical surfaces, as well as for high precision flattening of semiconductor, metallic or plastic surfaces. This tool consists of no moving parts, fabricated in stainless steel and abrasion resistant ceramic materials for some parts.

With this tool it is possible to grind / polish surfaces of up to 1 m in diameter; although it is possible to use arrays of two or more tools in order to work on larger surfaces. The wide spectrum of tool sizes that can be used, make this tool ideal for high precision applications in small optical parts, large surfaces as well as optical quality flattening of semiconductor surfaces.

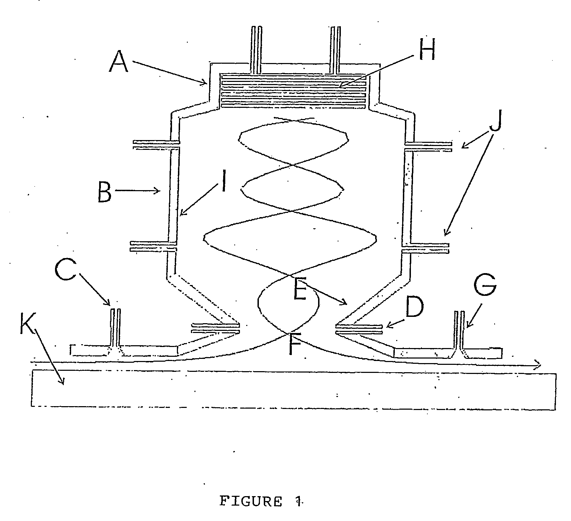

The present invention is a modular and interchangeable tool conformed of machined cylindrical stainless steel or ceramic sections that make up each stage (Fig 1.). A set of screws located in the periphery of the tool body, secure each stage in a stack. The tool consists of: a mixing stage (A), one or more rotational acceleration stages (B), an aerostatic suspension system (C), a throat actuator (D), an exit nozzle (E), a divergent radial nozzle (F) and an annular material recovering groove (G).

The mixing stage (A) controls the flux density by means of a porous cavity (H).

The acceleration chambers (B) are in turn conformed by one or more cylindrical cavities (I), characterized by a hydrodynamically optimized geometry, with a series of peripherally machined power injectors (J).

The aerostatic suspension system (C) produces a fluid cushion that allows the positioning of the tool with respect to the surface (K), by means of a series of aerostatic bearings, located in the periphery of the divergent section of the tool nozzle (D).

The throat actuator (D) consists of a continuous peripheral injector that controls the diameter of the exit nozzle.

The exit nozzle (E) is a device made of stainless steel or ceramic, characterized by an optimized hydrodynamic geometry. It consists of a throat and a jet actuator, which in turn are shaped by a continuous peripheral injector, a stator and a distribution ring.

The divergent radial nozzle (F) is a stainless steel device with an optimized geometry which produces a uniform and parallel flux with respect to the working surface (K), such that the abrasive particles only graze it.

The annular material recovery ring (G) retrieves the residual abrasive material generated during the polishing process by means of a suction device.

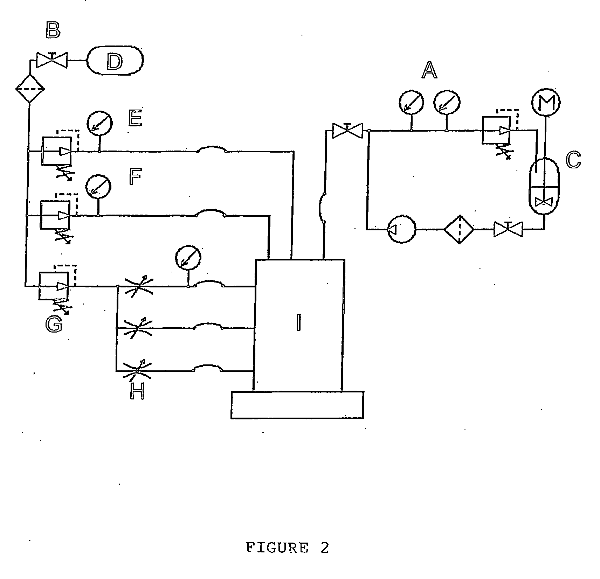

The tool, subject of the invention, (I) is fed by a hydro-pneumatic and control system (Fig. 2), conformed by liquid (A) and gas (B) subsystems. The liquid supply system consists of a permanently agitated container (C), an adequate pump, a hydraulic line with return, a pressure regulator and an electro-valve.

The gas supply system is conformed by a gas tank (D), a compressor, a three arm manifold with pressure regulators for each arm (E, F, G) and three sub-branches with respective variable flux restrictors (H).

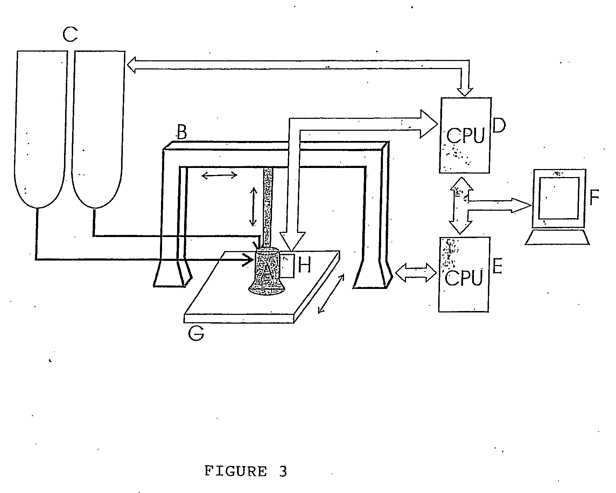

For the tool operation a control system like the one shown in Figure 3 can be used. The tool (A) is installed on a Cartesian or polar CNC machine (B) controlled numerically (E). The system includes feeding tanks (C) and a series of sensors and transducers (H) that regulate all operating parameters of the tool by means of a control system (D). A computer (F) coordinates the tool as well as the CNC machine by means of a user interface.

### Examples

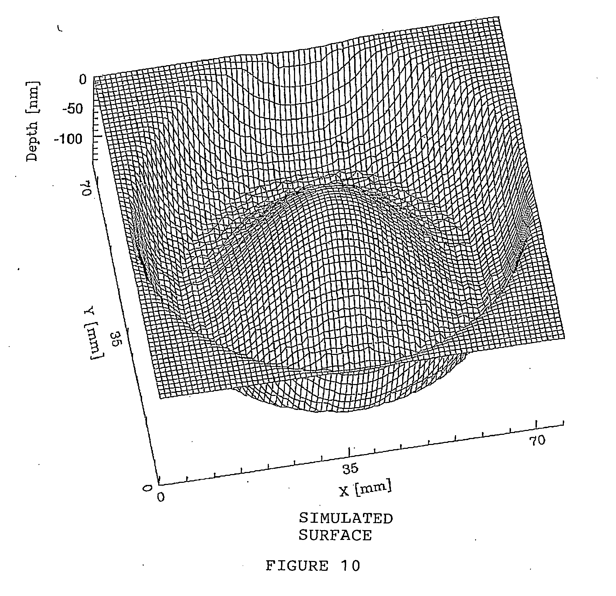

This new hydrodynamic radial polishing tool, that allows to locally polish optical surfaces with controlled wear, has been subject to a series of performance tests, using different types and sizes of abrasive granules, at different velocities and considering different heights of the tool with respect to the working surface. The experimental results achieved with this tool on different surfaces of between 15 and 20 cm in diameter are shown:

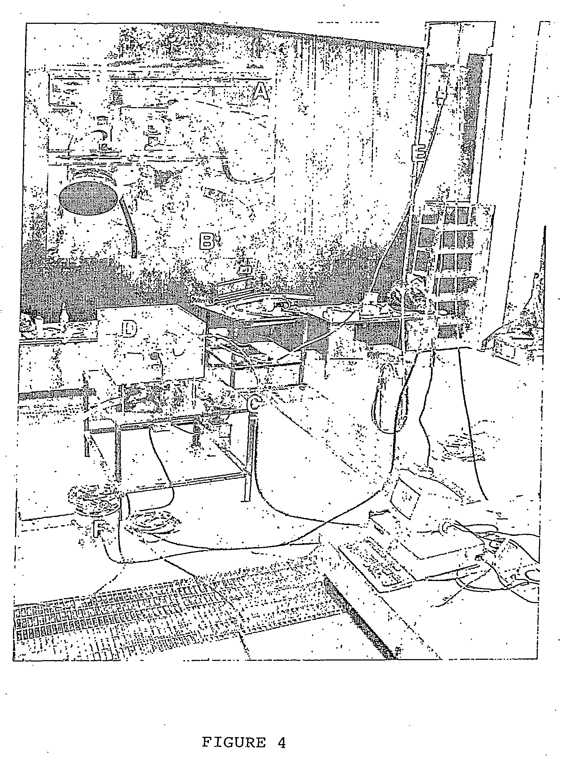

Figure 4 shows the polishing laboratory where the preliminary polishing tests were performed, using a prototype of the invention. The insert is a close-up of the polishing machine with the installed polishing tool. The r-θ-z machine where the tool is installed, is shown. The entire ensemble is located inside a clear and sealed cover. The feed lines, discharge container and control system can be seen.

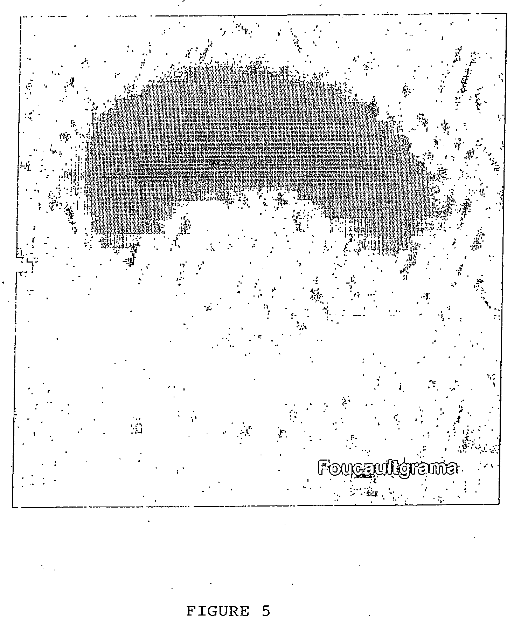

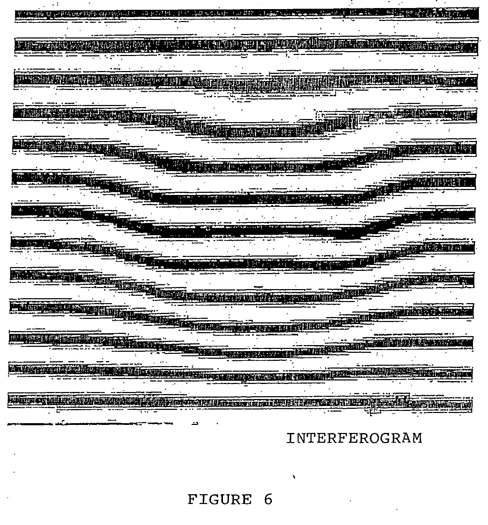

Figures 5 and 6 show a foucaultgram and an interferogram of the experimental static wear footprint.

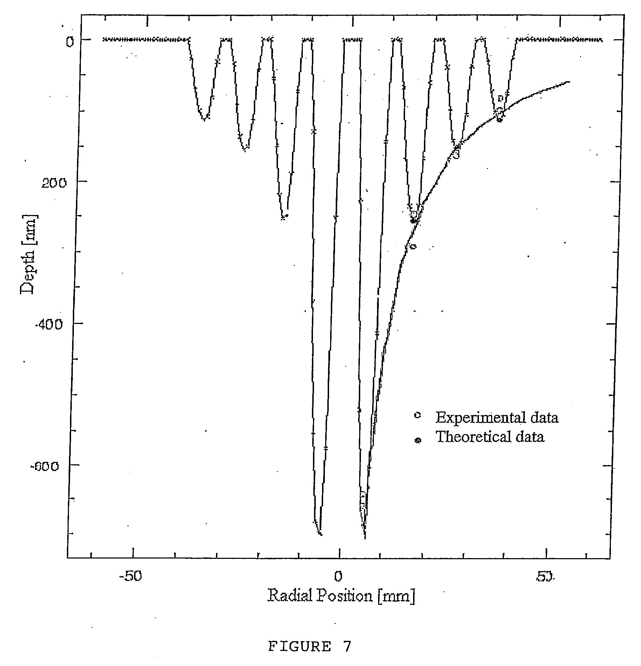

Figure 7 shows the transversal wear profile of a set of circular grooves generated with the tool to confront its performance with the theoretical model.

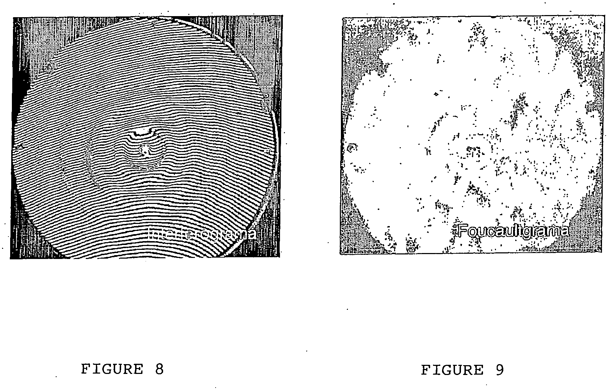

Figures 8 and 9 show two optical methods for measuring the surface of Figure 7. An interferogram and a foucaltgram show the grooves generated with these experiments.
   The tool presented here can polish aspheric surfaces such as a correcting Schmidt surface. Figure 10 shows a numerical simulation of such a surface which was used to program the tool controller in order to generate this surface.

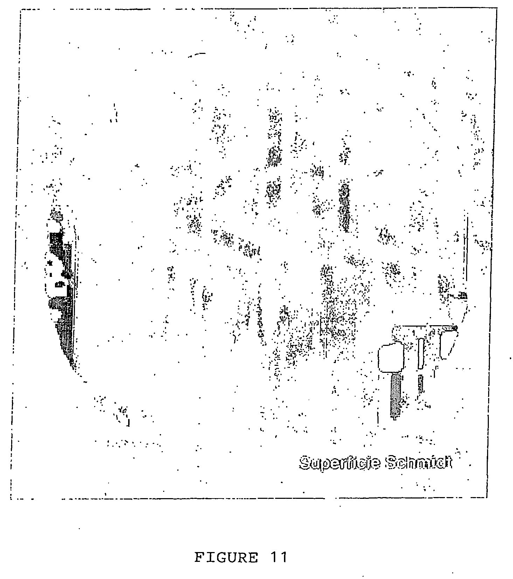

Figure 11 shows a computer reconstruction of the interferometrically analysed wavefront of the Schmidt surface that was polished using the tool. The surface accuracy is 13 nm rms. The observed stains correspond to phase deconvolution errors and do not correspond to wavefront errors.

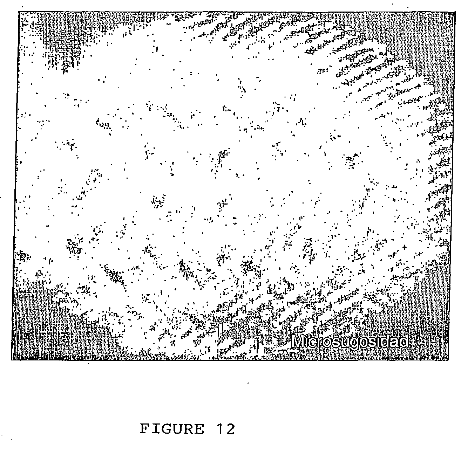

Figure 12 shows a micro-interferogram of the polished surface using the tool. The instrument is capable of detecting surface errors down to 2 nm. The fringe distortions represent a micro-roughness of approximately 25 nm rms. Abrasive particles of 5 µm were used.

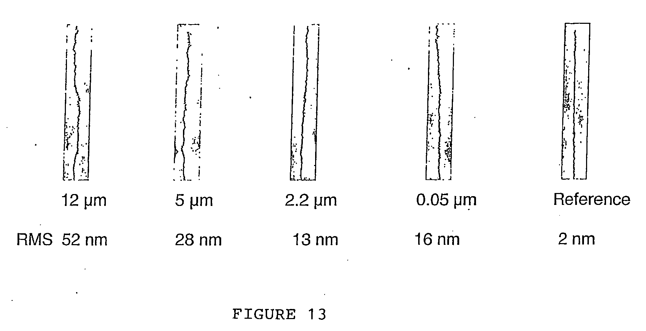

Figure 13 shows an interferometric fringe distortion analysis of surfaces polished with this tool using abrasive particles of different sizes and materials. The figure to the far right shows the fringe profile of an optical reference surface plate.

## Claims

1. High precision hydrodynamic polishing tool for fine grinding and polishing of flat or curved optical surfaces, as well as for the optical flattening of semiconductor and metal surfaces comprising:
several cylindrical sections comprising a mixing module (A), and an aerostatic suspension system
**characterized in that** said cylindrical sections consist of the mixing module (A) and the aerostatic suspension system (C), as well as a module comprising one or more rotational acceleration chambers (B), a throat actuator (D), an exit nozzle (E) and a radial, divergent nozzle (F), and wherein said cylindrical sections are made of previously machined stainless steel or ceramic, coupled to each other by means of a series of peripheral screws.

2. Tool in accordance with claim 1 wherein said tool comprises a mixing module (A) that allows the density control of the polishing mixture by means of an adequate porous cavity.

3. Tool in accordance with claim 1 wherein said rotational acceleration chambers (B) consist of one or more cylindrical cavities **characterized by** an optimized hydrodynamical geometry, and on the periphery of said chambers a set of power injectors is machined.

4. Tool in accordance with claim 1, in which the said aerostatic suspension system (C) generates a fluid layer over which the tool floats and that allows to adjust its position with respect to the surface by means of a series of said aerostatic bearings.

5. Tool in accordance with claim 1, in which the said throat actuator (D) consists of a continuous peripheral injector that controls the output nozzle diameter.

6. Tool in accordance with claim 1, in which the said output nozzle consists of a stainless steel or ceramic device, **characterized by** its hydrodynamically optimized geometry, and the output nozzle is composed of a throat and a jet actuator that in turn is composed of a continuous peripheral injector, a stator and a distribution ring.

7. Tool in accordance with claim 1, in which the divergent radial nozzle (F) is a stainless steel or ceramic device **characterized by** its hydrodynamically optimized geometry that produces a uniform radial and parallel flux towards the working surface such that the abrasive particles only graze the surface.

8. Tool in accordance with claim 1, in which the material recovery ring picks up the polishing process residual abrasive material by means of a suction mechanism.

9. Use of the tool of Claim 1 for the corrective grinding, fine polishing and cleansing of smooth surfaces, including surfaces coated with metals and thin films, of diverse rigid and semi-rigid materials of medium and high hardness as well as for the polishing and flattening of semiconductor surfaces.

## Patentansprüche

1. Hydrodynamisches Hochpräzisions-Polierwerkzeug für das Feinschleifen und Polieren von ebenen oder gekrümmten optischen Oberflächen sowie für das optische Einebnen von Halbleiter- und Metalloberflächen, aufweisend:
mehrere zylindrischen Bereiche mit einem Mischmodul (A) und einem aerostatischen Aufhängungssystem,
**dadurch gekennzeichnet, dass** die zylindrischen Bereiche aus dem Mischmodul (A) und dem aerostatischen Aufhängungssystem (C) sowie aus einem Modul mit einer oder mehreren Rotationsbeschleunigungskammern (B), einem Verengungs-Aktuator (D), einer Austrittsdüse (E) und einer radialen divergierenden Düse (F) bestehen, und wobei die zylindrischen Bereiche aus vorab spanend bearbeiteten rostfreiem Stahl oder Keramik hergestellt sind und mittels einer Reihe von peripheren Schrauben miteinander gekoppelt sind.

2. Werkzeug nach Anspruch 1,
wobei das Werkzeug ein Mischmodul (A) aufweist, das die Dichtesteuerung der Poliermischung mittels eines adäquaten porösen Hohlraums ermöglicht.

3. Werkzeug nach Anspruch 1,
wobei die Rotationsbeschleunigungskammern (B) aus einem oder mehreren zylindrischen Hohlräumen bestehen, die durch eine optimierte hydrodynamische Geometrie gekennzeichnet sind, und wobei an der Peripherie der Kammern ein Satz von Leistungs-Injektoren spanend gearbeitet ist.

4. Werkzeug nach Anspruch 1,
bei dem das aerostatische Aufhängungsystem (C) eine Fluidschicht erzeugt, über die das Werkzeug gleitet und die es erlaubt, die Position des Werkzeugs in Bezug auf die Oberfläche mittels einer Reihe der aerostatischen Lager einzustellen.

5. Werkzeug nach Anspruch 1,
bei dem der Verengungs-Aktuator (D) aus einem durchgehenden peripheren Injektor besteht, der den Austrittsdüsendurchmesser steuert.

6. Werkzeug nach Anspruch 1,
bei dem die Austrittsdüse aus einer Vorrichtung aus rostfreiem Stahl oder Keramik besteht, die durch ihre hydrodynamisch optimierte Geometrie gekennzeichnet ist, und wobei die Austrittsdüse aus einer Verengung und einem Strahl-Aktuator besteht, der wiederum aus einem kontinuierlichen peripheren Injektor, einem Stator und einem Verteilerring gebildet ist.

7. Werkzeug nach Anspruch 1,
bei dem die divergierende radiale Düse (F) eine Vorrichtung aus rostfreiem Stahl oder Keramik ist, die durch ihre hydrodynamisch optimierte Geometrie gekennzeichnet ist, die einen gleichmäßigen radialen und parallelen Fluss in Richtung auf die Arbeitsfläche erzeugt, so dass die Schleifpartikel die Oberfläche nur streifen.

8. Werkzeug nach Anspruch 1,
bei dem der Material-Rückgewinnungsring das restliche Polierprozess-Schleifmaterial mittels eines Saugmechanismus aufnimmt.

9. Verwendung des Werkzeugs gemäß Anspruch 1 zum Korrekturschleifen, Feinschleifen und Reinigen von glatten Oberflächen, einschließlich Oberfläche, die mit Metallen und Dünnschichten beschichtet sind, von verschiedenen starren und halbstarren Materialien mittlerer und hoher Härte

## Revendications

1. Outil hydrodynamique de polissage de haute précision pour le meulage fin et le polissage de surfaces optiques plates ou courbes, ainsi que pour l'aplatissement optique de surfaces semi-conductrices et métalliques comprenant plusieurs sections cylindriques comprenant un module de mélange (A) et un système de suspension aérostatique, **caractérisé en ce que** les dites sections cylindriques sont composées du module de mélange (A) et du système de suspension aérostatique (C) ainsi que d'un module comprenant une ou plusieurs chambres d'accélération rotationnelle (B), un actionneur de contraction (D), une buse de sortie (E) et une buse radiale divergente (F), et **en ce que** les dites sections cylindriques sont réalisées en acier inoxydable ou en céramique précédemment usinés, couplées les unes aux autres à l'aide d'une série de vis périphériques.

2. Outil selon la revendication 1, **caractérisé en ce que** le dit outil comprend un module de mélange (A) qui permet le contrôle de la densité du mélange de polissage au moyen d'une cavité à la porosité adéquate.

3. Outil selon la revendication 1, **caractérisé en ce que** les dites chambres d'accélération rotationnelle (B) consistent en une ou plusieurs cavités cylindriques **caractérisées par** une géométrie hydrodynamique optimisée, et en ce que sur la périphérie des dites chambres un ensemble d'injecteurs sous pression est usiné.

4. Outil selon la revendication 1, dans lequel le dit système de suspension aérostatique (C) génère une couche de fluide sur laquelle l'outil flotte et qui permet d'ajuster sa position par rapport à la surface au moyen d'une série des dits roulements aérostatiques.

5. Outil selon la revendication 1, **caractérisé en ce que** le dit actionneur de contraction (D) consiste en un injecteur périphérique continu qui contrôle le diamètre de la buse de sortie.

6. Outil selon la revendication 1 dans lequel la dite buse de sortie consiste en un dispositif d'acier inoxydable ou de céramique, **caractérisé par** sa géométrie hydrodynamiquement optimisée et en ce que la buse de sortie est composée d'un actionneur de contraction et un jet qui est à son tour composé d'un injecteur périphérique continu, d'un stator et d'un anneau de distribution.

7. Outil selon la revendication 1, **caractérisé en ce que** la buse radiale divergente (F) est un dispositif en acier inoxydable ou en céramique, **caractérisé par** sa géométrie hydrodynamiquement optimisée qui produit un flux radial et parallèle uniforme en direction de la surface de travail de façon à ce que les particules abrasives ne fassent qu'effleurer la surface.

8. Outil selon la revendication 1, dans lequel l'anneau de récupération de matériau récupère les matériaux abrasifs résiduels du procédé de polissage au moyen d'un mécanisme d'aspiration.

9. Utilisation de l'outil selon la revendication 1 pour le meulage correctif, le polissage fin et le nettoyage de surfaces lisses, comprenant des surfaces revêtues de métaux et de films fins, de matériaux divers rigides et semi-rigides de dureté moyenne et élevée ainsi que pour le polissage et l'aplatissement de surfaces semi-conductrices.
